# EUROPEAN PATENT APPLICATION

(11) **EP 4 525 588 A2**
(43) Date of publication of application: **19.03.2025**
(21) Application number: 24198089.5
(22) Date of filing: 03.09.2024
(51) Int. Cl.: H10F 77/20

(54) **BACK CONTACT SOLAR CELL AND PHOTOVOLTAIC MODULE**

(30) Priority: 12.09.2023 CN 202311179614
(71) Applicant: Longi Green Energy Technology Co., Ltd., Xi'an, Shaanxi 710100 (CN)
(72) Inventor: TONG, Hongbo, SHAANXI 710100 (CN); YU, Long, SHAANXI 710100 (CN); CHEN, Shi, SHAANXI 710100 (CN); LI, Hua, SHAANXI 710100 (CN)
(74) Representative: Pfenning, Meinig & Partner mbB

(57) **Abstract**

This application discloses a back contact solar cell and a photovoltaic module, and relates to the field of solar cell technologies, to resolve problems that a metal composite loss exists on a surface of the back contact solar cell and solar cell efficiency of the back contact solar cell is reduced because bus electrodes and collector electrodes made of metal are completely in direct contact with a solar cell body. The back contact solar cell includes a solar cell body, a conductive contact layer, and a group of the positive electrodes and a group of the negative electrodes each including a plurality of collector electrodes and a plurality of bus electrodes. A plurality of first conductive contact layers extend in a first direction and are spaced apart in a second direction. A plurality of second conductive contact layers extend in the second direction and are spaced apart in the first direction. The first direction is different from the second direction. Each of the bus electrodes is connected to collector electrodes having the same polarity as that of the bus electrode. A projection of a collector electrode on the solar cell body at least partially overlaps with a projection of a first conductive contact layer on the solar cell body. A projection of a bus electrode on the solar cell body at least partially overlaps with a projection of a second conductive contact layer on the solar cell body.

## Description

### CROSS-REFERENCE TO RELATED APPLICATIONS

This application claims priority and benefits to Chinese Patent Application No. 202311179614.6, filed on September 12, 2023, which is incorporated herein by reference in its entirety.

### TECHNICAL FIELD

This application relates to the field of solar cell technologies, and in particular, to a back contact solar cell and a photovoltaic module.

### BACKGROUND

A solar cell is a device that uses solar energy and directly converts sunlight into electrical energy through a photoelectric effect or a photochemical effect. When both positive electrodes and negative electrodes included in the solar cell are located on a back surface of the solar cell, the solar cell is a back contact solar cell. Existing back contact solar cells include a metal wrap through (MWT) solar cell, an interdigitated back contact (IBC) solar cell, and the like. A significant characteristic of the IBC solar cell is that both an emitter and a metal contact are located on the back surface of the solar cell, and the front surface of the solar cell is not blocked or affected by a metal electrode. Therefore, the IBC solar cell has a higher short-circuit current Isc. The back surface of the IBC solar cell can also allow for a wide metal grid line to reduce the series resistance Rs, so that a fill factor (FF) can be improved. In addition, the solar cell with the front surface being not blocked has high conversion efficiency and is aesthetic, and all-back-contact electrodes are easy to assemble.

The IBC solar cell generally includes structures such as a solar cell body, collector electrodes, and bus electrodes. The collector electrodes and the bus electrodes are generally made of metal.

In conventional technologies, the bus electrodes and the collector electrodes made of metal are completely in direct contact with the solar cell body, resulting in a large metal composite loss on the surface of the back contact solar cell. Consequently, solar cell efficiency of the back contact solar cell is reduced.

### SUMMARY

An objective of this application is to provide a back contact solar cell and a photovoltaic module, to reduce or eliminate a metal composite loss on a surface of the back contact solar cell, thereby improving solar cell efficiency of the back contact solar cell.

To implement the foregoing objective, according to a first aspect, this application provides a back contact solar cell. The back contact solar cell includes: a solar cell body, a conductive contact layer formed on a back surface of the solar cell body, and positive electrodes and negative electrodes located on the conductive contact layer. Each of a group of the positive electrodes and a group of the negative electrodes includes a plurality of collector electrodes and a plurality of bus electrodes. The conductive contact layer includes a plurality of first conductive contact layers and a plurality of second conductive contact layers. The plurality of collector electrodes included in the group of the positive electrodes and the plurality of collector electrodes included in the group of the negative electrodes extend in a first direction and are alternately spaced apart in a second direction. The plurality of first conductive contact layers extend in the first direction and are spaced apart in the second direction. The plurality of bus electrodes included in the group of the positive electrodes and the plurality of bus electrodes included in the group of the negative electrodes extend in the second direction and are alternately spaced apart in the first direction. The plurality of second conductive contact layers extend in the second direction and are spaced apart in the first direction. The first direction is different from the second direction. Each of the bus electrodes is connected to collector electrodes having the same polarity as that of the bus electrode. A projection of a collector electrode on the solar cell body at least partially overlaps with a projection of a first conductive contact layer on the solar cell body. A projection of a bus electrode on the solar cell body at least partially overlaps with a projection of a second conductive contact layer on the solar cell body.

Compared with conventional technologies, according to the back contact solar cell provided in this application, because the projection of the collector electrode on the solar cell body at least partially overlaps with the projection of the first conductive contact layer on the solar cell body, there is a case in which the collector electrode is in partial direct contact with the solar cell body or the collector electrode is not in contact with the solar cell body at all. In this case, compared with the conventional technologies, a metal composite loss between the collector electrode and the solar cell body can be reduced or eliminated, thereby improving solar cell efficiency of the back contact solar cell. Further, because the projection of the bus electrode on the solar cell body at least partially overlaps with the projection of the second conductive contact layer on the solar cell body, there is a case in which the bus electrode is in partial direct contact with the solar cell body or the bus electrode is not in contact with the solar cell body at all. In this case, compared with the conventional technologies, a metal composite loss between the bus electrode and the solar cell body can be further reduced or eliminated, and an open-circuit voltage of the back contact solar cell can increase, thereby improving the solar cell efficiency of the back contact solar cell. Based on the above, the back contact solar cell provided in this application is used, so that a metal composite loss on a surface of the back contact solar cell can be reduced or eliminated, thereby improving the solar cell efficiency of the back contact solar cell.

In an implementation, each of the collector electrodes includes collector electrode sections, and each of the collector electrode sections is spaced apart from a bus electrode adjacent to the collector electrode and having a polarity opposite to that of the collector electrode; and a length of a first conductive contact layer corresponding to any collector electrode section located between two adjacent bus electrodes is greater than or equal to 5 mm and less than or equal to 50 mm, and a length direction of the first conductive contact layer is consistent with the first direction.

With the foregoing technical solution, because the length of the first conductive contact layer is greater than or equal to 5 mm, in this case, an excessively short distance for the first conductive contact layer to collect a current caused by an excessively small length of the first conductive contact layer can be avoided. In this way, a capability of the first conductive contact layer to collect the current can be ensured, and the solar cell efficiency of the back contact solar cell can be improved. Further, because the length of the first conductive contact layer is less than or equal to 50 mm, in this case, more first conductive contact layers can be formed on the solar cell body, to form more second conductive contact layers, so that more bus electrodes can be formed. In this way, the solar cell efficiency of the back contact solar cell can be improved, and the open-circuit voltage and a passivation effect of the back contact solar cell can be improved.

In an implementation, the projection of the collector electrode on the solar cell body is located within the projection of the first conductive contact layer on the solar cell body.

With the foregoing technical solution, while it is ensured that the collector electrode is in contact with the first conductive contact layer, the metal composite loss between the collector electrode and the solar cell body can be reduced or eliminated, and the open-circuit voltage of the back contact solar cell can increase, thereby improving the solar cell efficiency of the back contact solar cell. Further, because the first conductive contact layer is in good contact with the collector electrode, in this case, the collector electrode can collect a current, thereby facilitating transmission of the current.

In an implementation, the projection of the bus electrode on the solar cell body is located within the projection of the second conductive contact layer on the solar cell body.

With the foregoing technical solution, while it is ensured that the bus electrode is in contact with the second conductive contact layer, the metal composite loss between the bus electrode and the solar cell body can be reduced or eliminated, and the open-circuit voltage of the back contact solar cell can increase, thereby improving the solar cell efficiency of the back contact solar cell. Further, blocking by the second conductive contact layer on the solar cell body can be reduced or eliminated, thereby reducing impact on light absorption by the back contact solar cell, and improving the solar cell efficiency of the back contact solar cell.

In an implementation, a width of the first conductive contact layer is greater than or equal to 50 µm and less than or equal to 400 µm, and a width direction of the first conductive contact layer is consistent with the second direction.

With the foregoing technical solution, in a process of manufacturing the back contact solar cell, the collector electrode needs to be printed above the first conductive contact layer. In a current printing technology, the collector electrode can be printed on only a line with a minimum width of about 50 µm (namely, the first conductive contact layer in this application). If a width of the line is excessively small, the projection of the collector electrode on the solar cell body cannot at least partially overlap with the projection of the first conductive contact layer on the solar cell body, and the collector electrode does not fall within a first conductive contact region generated by the first conductive contact layer. In other words, when the width of the first conductive contact layer is less than 50 µm, a printing offset of the collector electrode is caused. The printing offset causes various parameters of the back contact solar cell to greatly decrease. In the most severe case, first conductivity type regions and second conductivity type regions (namely, N regions and P regions of the back contact solar cell in the conventional technologies) of the back contact solar cell are short-circuited, causing the solar cell efficiency of the back contact solar cell to be drastically reduced. In this way, the width of the first conductive contact layer needs to be greater than or equal to 50 µm.

Because the width of the first conductive contact layer is less than or equal to 400 µm, in this case, an excessively small quantity of first conductive contact layers caused by an excessively large width of the first conductive contact layer can be avoided, thereby avoiding reducing a quantity of collector electrodes. In this way, a decrease in a contact area between metal and a semiconductor can be avoided, thereby avoiding a decrease in a fill factor of the back contact solar cell. Further, when the width of the first conductive contact layer is less than or equal to 400 µm, a spacing between two adjacent first conductive contact layers can be large, that is, a size of a gap in an up-down direction can be large. Because an up-down offset in the printing offset has the largest impact, the N regions and the P regions are connected over a large area and therefore short-circuited. In this way, when the width of the first conductive contact layer is less than or equal to 400 µm, printing difficulty can be reduced, the printing offset can be reduced, and a printing yield of the back contact solar cell can increase. Still further, a composition loss can be avoided and a printing offset rate can be reduced while contact is ensured, so that both the solar cell efficiency and the yield of the back contact solar cell are improved.

In an implementation, a width of the second conductive contact layer is greater than or equal to 50 µm and less than or equal to 400 µm, and a width direction of the second conductive contact layer is consistent with the first direction.

With the foregoing technical solution, because the width of the second conductive contact layer is greater than or equal to 50 µm, in this case, the open-circuit voltage, the fill factor, and the solar cell efficiency of the back contact solar cell can be improved. Further, because the width of the second conductive contact layer is less than or equal to 400 µm, in this case, an excessively small length of a first conductive contact layer located between two adjacent second conductive contact layers caused by an excessively large width of the second conductive contact layer can be avoided, thereby avoiding an excessively short distance for the first conductive contact layer and a collector electrode corresponding to the first conductive contact layer to collect a current, and avoiding affecting the yield. In this way, impact on collection of the first conductive contact layer on the current can be avoided, and the yield of the back contact solar cell can be improved.

In an implementation, a first spacing between the first conductive contact layer corresponding to the collector electrode section and a second conductive contact layer corresponding to the bus electrode adjacent to the collector electrode and having the polarity opposite to that of the collector electrode is greater than or equal to 5 µm and less than or equal to 100 µm, and a direction of the first spacing is consistent with the first direction.

With the foregoing technical solution, because the first spacing is greater than or equal to 5 µm, in this case, conduction between a first conductivity type region and a second conductivity type region (namely, an N region and a P region of the back contact solar cell in the conventional technologies) can be avoided, thereby avoiding a short circuit. In addition, a printing offset can be reduced or avoided, to further reduce or avoid a short circuit caused by conduction of the N region and the P region. Further, because the first spacing is less than or equal to 100 µm, in this case, excessively small areas of the N region and the P region when the first spacing is greater than 100 µm can be reduced or avoided, to reduce or avoid passivation deterioration, a decrease in a contact area between metal and a semiconductor, and a decrease in a fill factor of the back contact solar cell caused by the excessively small areas of the N region and the P region, thereby ensuring or improving the solar cell efficiency of the back contact solar cell.

In an implementation, a second spacing between any two adjacent first conductive contact layers is greater than or equal to 5 µm and less than or equal to 100 µm, and a direction of the second spacing is consistent with the second direction.

With the foregoing technical solution, because the second spacing is greater than or equal to 5 µm, in this case, a short circuit between two collector electrode sections having opposite polarities caused by an excessively short distance between two adjacent first conductive contact layers can be avoided, to ensure that the collector electrode sections are connected to corresponding bus electrodes, thereby ensuring quality of the back contact solar cell, and ensuring the solar cell efficiency and a yield of the back contact solar cell. Further, because the second spacing is less than or equal to 100 µm, in this case, excessively small areas of a first conductivity type region and a second conductivity type region caused by an excessively large second spacing can be avoided, to avoid a decrease in the fill factor, thereby ensuring the solar cell efficiency and the yield of the back contact solar cell.

In an implementation, a thickness of the conductive contact layer is greater than or equal to 30 nm and less than or equal to 600 nm, and a thickness direction of the conductive contact layer is perpendicular to the first direction and the second direction.

With the foregoing technical solution, because the thickness of the conductive contact layer is greater than or equal to 30 nm, in this case, a probability that materials for manufacturing the bus electrodes and the collector electrodes pass through the solar cell body can be reduced or eliminated, to reduce or eliminate the metal composite loss on the surface of the back contact solar cell, thereby improving the solar cell efficiency of the back contact solar cell. Because the thickness of the conductive contact layer is less than or equal to 600 nm, in this case, light absorption by the conductive contact layer can be reduced, to reduce parasitic light absorption, thereby avoiding a severe decrease in a current of the back contact solar cell. In addition, bending and deformation of the back contact solar cell caused by unconcentrated stress distribution can also be avoided, thereby reducing a fragmentation rate in a production process, and improving a yield of the back contact solar cell.

In an implementation, the solar cell body includes first conductivity type regions, second conductivity type regions, and isolation regions; the first conductivity type regions and the second conductivity type regions have opposite conductivity types and are alternately distributed; each of the isolation regions is located between a first conductivity type region and a second conductivity type region; one of a positive electrode and a negative electrode is located in the first conductivity type region, and the other of the positive electrode and the negative electrode is located in the second conductivity type region; and a ratio of a sum of areas of the first conductivity type regions and the second conductivity type regions to an area of the solar cell body is greater than or equal to 10% and less than or equal to 50%.

With the foregoing technical solution, because the first conductivity type regions and the second conductivity type regions are alternately distributed, in this case, when it is ensured that the first conductivity type regions and the second conductivity type regions are evenly distributed on the entire back surface of the solar cell body, it can be ensured that the first conductivity type regions and the second conductivity type regions of the back contact solar cell have large areas, and overall transmission of currents to the first conductivity type regions and the second conductivity type regions can also be facilitated, thereby avoiding a large composition loss of carriers caused by an excessively long transmission distance.

In an implementation, the solar cell body includes first conductivity type regions, second conductivity type regions, and isolation regions; the first conductivity type regions and the second conductivity type regions have opposite conductivity types and are alternately distributed; each of the isolation regions is located between a first conductivity type region and a second conductivity type region; and a ratio of a total area of the isolation regions to an area of the solar cell body is greater than or equal to 1% and less than or equal to 10%.

With the foregoing technical solution, the first conductivity type regions and the second conductivity type regions can be completely separated, and it can also be ensured that distribution areas of the first conductivity type regions and the second conductivity type regions are not occupied too much. The isolation regions can provide passive regions with a specific area having a positive gain effect on the solar cell efficiency. If a proportion of the total area of the isolation regions is less than 1%, preparation of the isolation regions is difficult, and an isolation effect and a passivation effect are poor; and if the proportion of the total area of the isolation regions is greater than 10%, an effective power generation area of the solar cell is reduced. Based on the ratio range, isolation and the passivation effect of the entire back contact solar cell and contact between metal and a semiconductor can be ensured, so that the open-circuit voltage and a fill factor of the back contact solar cell are improved, thereby improving the solar cell efficiency of the back contact solar cell.

In an implementation, a ratio of a total area of the second conductive contact layers to an area of the conductive contact layer is greater than or equal to 2% and less than or equal to 20%.

With the foregoing technical solution, because the ratio is greater than or equal to 2%, in this case, it can be ensured that there is a case in which the bus electrode is in partial direct contact with the solar cell body or the bus electrode is not in contact with the solar cell body at all, thereby reducing or eliminating the metal composite loss between the bus electrode and the solar cell body. Further, because the ratio is less than or equal to 20%, in this case, distribution areas of the first conductivity type regions and the second conductivity type regions can be ensured, and the total area of the second conductive contact layers can be ensured, thereby avoiding a decrease in a contact area between metal and a semiconductor caused by a decrease in the total area of the second conductive contact layers. In this way, a fill factor of the back contact solar cell can be ensured, thereby ensuring or improving the solar cell efficiency of the back contact solar cell.

In an implementation, a first conductive contact layer and a second conductive contact layer that are adjacent and have a same polarity intersect.

According to a second aspect, this application further provides a photovoltaic module, including the back contact solar cell according to the foregoing technical solutions.

Compared with the conventional technologies, beneficial effects of the photovoltaic module provided in this application are the same as the beneficial effects of the back contact solar cell in the foregoing technical solutions, and details are not described herein again.

### BRIEF DESCRIPTION OF THE DRAWINGS

Accompanying drawings described herein are used for providing a further understanding of this application, and form part of this application. Exemplary embodiments of this application and descriptions thereof are used for explaining this application, and do not constitute any inappropriate limitation to this application. In the accompanying drawings:
FIG. 1 is a schematic structural diagram 1 of a back contact solar cell in conventional technologies;
FIG. 2 is a schematic structural diagram 2 of a back contact solar cell in the conventional technologies;
FIG. 3 is a schematic structural diagram of a conductive contact layer according to an embodiment of this application;
FIG. 4 is a schematic structural diagram of a collector electrode and a conductive contact layer according to an embodiment of this application;
FIG. 5 is a schematic structural diagram of a bus electrode, a collector electrode, and a conductive contact layer according to an embodiment of this application;
FIG. 6 is a diagram of relationships between a length of a first conductive contact layer and a fill factor improvement value, a solar cell efficiency improvement value, and an open-circuit voltage improvement value according to an embodiment of this application;
FIG. 7 is a diagram of relationships between a width of a first conductive contact layer and a fill factor improvement value, a solar cell efficiency improvement value, and an open-circuit voltage improvement value according to an embodiment of this application;
FIG. 8 is a diagram of relationships between a quantity of first conductive contact layers and a fill factor improvement value, a yield improvement value, and an open-circuit voltage improvement value according to an embodiment of this application;
FIG. 9 is a diagram of relationships between a width of a second conductive contact layer and an open-circuit voltage improvement value, a fill factor improvement value, a solar cell efficiency improvement value, and a yield improvement value according to an embodiment of this application;
FIG. 10 is a diagram of relationships between a quantity of second conductive contact layers and a fill factor improvement value, a solar cell efficiency improvement value, and an open-circuit voltage improvement value according to an embodiment of this application;
FIG. 11 is a schematic enlarged view of a partial structure in FIG. 3 according to an embodiment of this application;
FIG. 12 is a diagram of relationships between a second spacing and a fill factor improvement value, a solar cell efficiency improvement value, a yield improvement value, and an open-circuit voltage improvement value according to an embodiment of this application;
FIG. 13 is a schematic diagram of a current flowing direction in a back contact solar cell according to an embodiment of this application;
FIG. 14 is a schematic diagram of series resistance in a back contact solar cell according to an embodiment of this application;
FIG. 15 is a schematic diagram of a current flowing direction when only first conductive contact layers are arranged according to an embodiment of this application;
FIG. 16 is a schematic diagram of a current flowing direction when first conductive contact layers and second conductive contact layers are arranged according to an embodiment of this application; and
FIG. 17 is a schematic structural diagram of a back contact solar cell according to an embodiment of this application.

Reference numerals:

| | | | | | |
|---|---|---|---|---|---|
| 1- | conductive contact layer; | 10- | first conductive contact layer; | 11- | second conductive contact layer; |
| 2- | positive electrode; | 3- | negative electrode; | 4- | collector electrode; |
| 40- | collector electrode section; | 5- | bus electrode; | | |
| 50- | first bus electrode; | | | | |
| 51- | second bus electrode; | 6- | first conductivity type region; | 7- | second conductivity type region; |
| 8- | isolation region; | 90- | first spacing; | 91- | second spacing; |
| 93- | N-region first conductive contact layer; | 94 | P-region first conductive contact layer; and | | |
| 95- | solar cell body. | | | | |

### DETAILED DESCRIPTION

To make the technical problems to be resolved in this application, the technical solutions, and beneficial effects more comprehensible, the following further describes this application in detail with reference to the accompanying drawings and embodiments. It should be understood that, the specific embodiments described herein are merely used for explaining this application, but are not intended to limit this application.

It should be noted that, when an element is referred to as "being fixed to" or "being arranged on" another element, the element may be directly on the another element, or may be indirectly on the another element. When an element is referred to as "being connected to" another element, the element may be directly connected to the another element, or may be indirectly connected to the another element.

In addition, the terms "first" and "second" are used for descriptive purposes only and are not to be construed as indicating or implying relative importance or implicitly indicating the number of technical features indicated. Therefore, a feature defined by "first" or "second" may explicitly or implicitly include one or more features. In the description of this application, unless otherwise explicitly and specifically limited, "a plurality of" means two or more; and unless otherwise explicitly and specifically limited, "at least one" means one or more than one.

In the description of this application, it should be understood that orientation or position relationships indicated by the terms such as "upper", "lower", "front", "rear", "left", and "right" are based on orientation or position relationships shown in the accompanying drawings, and are used only for ease and brevity of illustration and description of this application, rather than indicating or implying that the mentioned apparatus or element needs to have a particular orientation or needs to be constructed and operated in a particular orientation. Therefore, such terms should not be construed as limiting of this application.

In the description of this application, it should be noted that, unless otherwise explicitly specified or limited, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two elements, or an interaction relationship between two elements. A person of ordinary skill in the art may understand the specific meanings of the foregoing terms in this application according to specific situations.

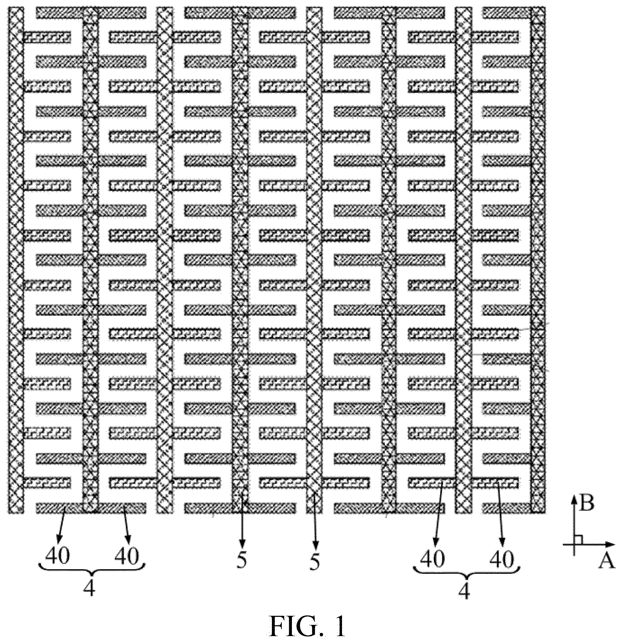

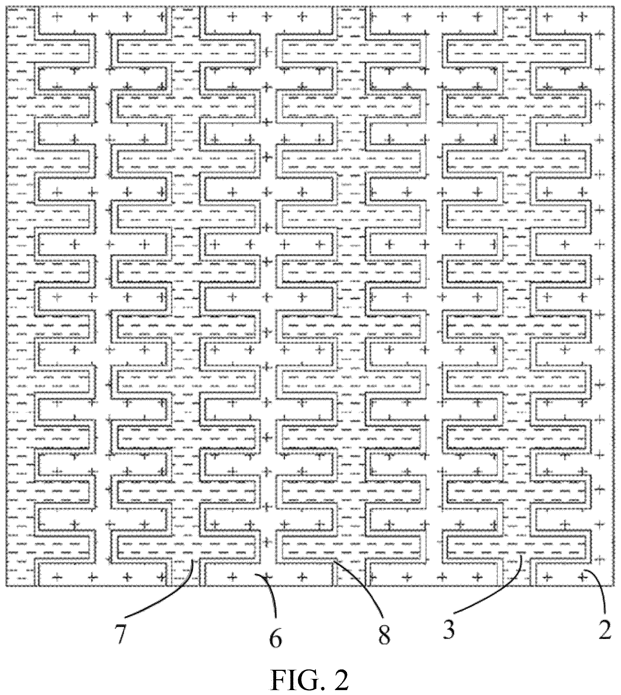

FIG. 1 and FIG. 2 show a structure of a back contact solar cell in the conventional technologies. FIG. 1 shows a plurality of collector electrodes 4 and a plurality of bus electrodes 5, where each of the collector electrodes 4 includes collector electrode sections 40. FIG. 2 shows first conductivity type regions 6, second conductivity type regions 7, and isolation regions 8. The first conductivity type regions 6 and the second conductivity type regions 7 have opposite conductivity types and are alternately distributed. Each of the isolation regions 8 is located between a first conductivity type region 6 and a second conductivity type region 7. One of a positive electrode 2 and a negative electrode 3 is located in the first conductivity type region 6, and the other of the positive electrode 2 and the positive electrode 3 is located in the second conductivity type region 7. As shown in FIG. 2, the positive electrode 2 is located in the first conductivity type region 6, and the negative electrode 3 is located in the second conductivity type region 7. It should be noted that, although FIG. 1 and FIG. 2 are described as representing the conventional technologies, FIG. 1 and FIG. 2 are merely intended to describe distribution of electrodes and two conductivity type regions, and an improvement in this application does not involve illustrated features. In other words, this application may also include the features shown in FIG. 1 and FIG. 2.

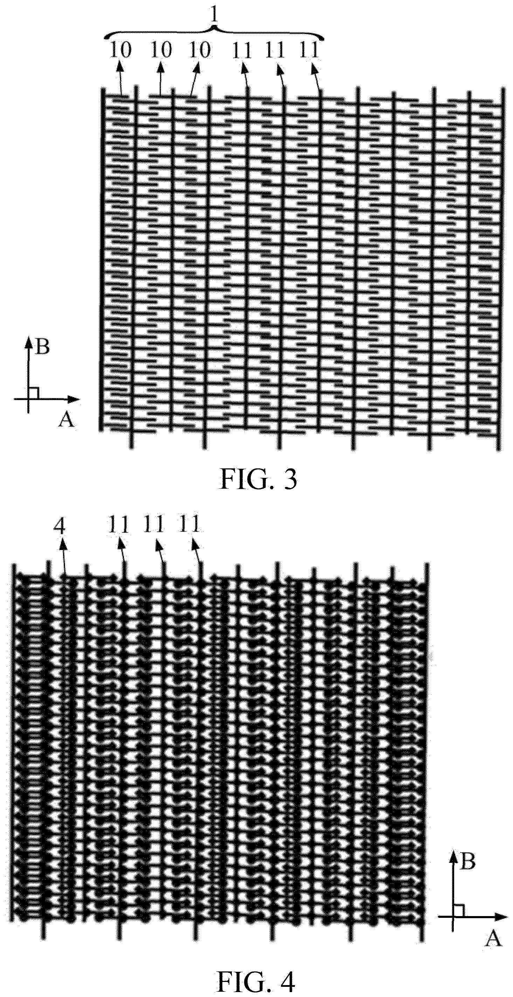

To resolve the foregoing technical problems, according to a first aspect, an embodiment of this application provides a back contact solar cell. Referring to FIG. 3 to FIG. 5 and FIG. 17 with reference to FIG. 1 and FIG. 2, the back contact solar cell includes: a solar cell body, a conductive contact layer 1 formed on a back surface of the solar cell body, and positive electrodes 2 and negative electrodes 3 located on the conductive contact layer 1. Each of a group of the positive electrodes 2 and a group of the negative electrodes 3 includes a plurality of collector electrodes 4 and a plurality of bus electrodes 5. The conductive contact layer 1 includes a plurality of first conductive contact layers 10, such as lateral lines shown in FIG. 3, and a plurality of second conductive contact layers 11, such as vertical lines shown in FIG. 3. For ease of description, overlaps between the lateral lines and the vertical lines in FIG. 3 are divided into the second conductive contact layers 11. The plurality of collector electrodes 4 included in the group of the positive electrodes 2 and the plurality of collector electrodes 4 included in the group of the negative electrodes 3 extend in a first direction A and are alternately spaced apart in a second direction B. A plurality of first conductive contact layers extend in a first direction and are spaced apart in a second direction. The plurality of bus electrodes 5 (referred to as first bus electrodes 50 for short) included in the group of the positive electrodes 2 and the plurality of bus electrodes 5 (referred to as second bus electrodes 51 for short) included in the group of the negative electrodes 3 extend in the second direction B and are alternately spaced apart in the first direction A. A plurality of second conductive contact layers extend in the second direction and are spaced apart in the first direction. The first direction A is different from the second direction B. Each of the bus electrodes 5 is connected to a plurality of collector electrodes 4 having the same polarity as that of the bus electrode. A projection of a single collector electrode 4 on the solar cell body at least partially overlaps with a projection of a corresponding first conductive contact layer 10 on the solar cell body. A projection of a single bus electrode 5 on the solar cell body at least partially overlaps with a projection of a corresponding second conductive contact layer 11 on the solar cell body. It should be understood that, FIG. 1 and FIG. 2 show the structure of the back contact solar cell in the conventional technologies, which are cited herein only for understanding the technical solutions and are not intended to be specifically limited. No conductive contact layer is arranged below both the collector electrode and the bus electrode.

A specific structure and a material of the solar cell body may be set according to an actual application scenario. This is not specifically limited herein. For example, the solar cell body may include a semiconductor substrate. The semiconductor substrate may be a silicon substrate, which is a monocrystalline silicon substrate in this embodiment, and may be a polysilicon substrate in other embodiments. The semiconductor substrate has a first surface and a second surface opposite to each other. The second surface corresponds to the back surface of the solar cell body. In a direction parallel to the second surface, the second surface has first regions and second regions alternately arranged in the first direction. Length extension directions of the first regions and the second regions are all parallel to the second direction. A P-type doped semiconductor layer is formed on or in the first region. An N-type doped semiconductor layer is formed on or in the second region. Doping concentrations of impurities in the P-type doped semiconductor layer and the N-type doped semiconductor layer may be set according to an actual application scenario, provided that the P-type doped semiconductor layer and the N-type doped semiconductor layer can be applied to the back contact solar cell provided in this embodiment of this application.

The conductive contact layer may be a combination of a doped polysilicon layer and a tunneling layer, for example, may be a combination of a P-type doped polysilicon layer and a tunneling layer, or a combination of an N-type doped polysilicon layer and a tunneling layer. For example, the tunneling layer may be a silicon dioxide tunneling layer. The tunneling layer is formed on the solar cell body, and the P-type doped polysilicon layer or the N-type doped polysilicon layer is formed on the tunneling layer.

The collector electrode is spaced apart from a bus electrode having a polarity opposite to that of the collector electrode and adjacent to the collector electrode, to avoid a short circuit. Further, in this specification, the "bus electrode" is a structure for bus that intersects the collector electrode; and may be a main gate electrode that intersects the collector electrode, where the main gate electrode plays a role of collecting currents; or may be a bus bar or an interconnection bar that intersects the collector electrode, for example, a welding ribbon or a wire, where the bus bar or the interconnection bar is used to replace the main grid electrode and plays the role of collecting the currents. It should be pointed out that, the single collector electrode in this application may also be a single collector electrode section, particularly when the bus electrode is the main gate electrode. Specific structures, forming materials, and the like of the collector electrode and the bus electrode may be set and selected according to an actual situation, and are not specifically limited herein.

In that "the plurality of bus electrodes included in the group of the positive electrodes and the plurality of bus electrodes included in the group of the negative electrodes extend in the second direction and are alternately spaced apart in the first direction", a quantity of bus electrodes included in the group of the positive electrodes and a quantity of bus electrodes included in the group of the negative electrodes may be equal, in other words, the back contact solar cell includes an even quantity of bus electrodes. Certainly, the quantity of bus electrodes included in the group of the positive electrodes and the quantity of bus electrodes included in the group of the negative electrodes may alternatively be not equal, in other words, the back contact solar cell includes an odd quantity of bus electrodes.

In an optional manner, a quantity of collector electrodes is greater than or equal to a quantity of first conductive contact layers.

For that "the plurality of first conductive contact layers extend in the first direction and are spaced apart in the second direction", there are the following two different cases. It should be understood that, the following descriptions are merely for understanding and are not intended to be specifically limited.

Example 1: When the quantity of first conductive contact layers is equal to the quantity of collector electrodes, the plurality of first conductive contact layers extend in the first direction, and first conductive contact layers having different polarities are alternately spaced apart in the second direction.

Example 2: When the quantity of first conductive contact layers is less than the quantity of collector electrodes, for example, first conductive contact layers are arranged below only 80% of the quantity of collector electrodes, the plurality of first conductive contact layers extend in the first direction and are spaced apart in the second direction.

In an optional manner, a quantity of bus electrodes is greater than or equal to a quantity of second conductive contact layers.

For that "the plurality of second conductive contact layers extend in the second direction and are spaced apart in the first direction", there are the following two different cases. It should be understood that, the following descriptions are merely for understanding and are not intended to be specifically limited.

Example 1: When the quantity of second conductive contact layers is equal to the quantity of bus electrodes, the plurality of second conductive contact layers extend in the second direction, and second conductive contact layers having different polarities are alternately spaced apart in the first direction.

Example 2: When the quantity of second conductive contact layers is less than the quantity of bus electrodes, for example, second conductive contact layers are arranged below only 80% of the quantity of bus electrodes, the plurality of second conductive contact layers extend in the second direction and are spaced apart in the first direction.

Referring to FIG. 3 to FIG. 5 with reference to FIG. 1 and FIG. 2, in the back contact solar cell provided in this embodiment of this application, the projection in this application is an orthographic projection unless otherwise specifically described. Because the projection of the single collector electrode on the solar cell body at least partially overlaps with the projection of the corresponding first conductive contact layer on the solar cell body, there is a case in which the single collector electrode is in partial direct contact with the solar cell body or the collector electrode is not in contact with the solar cell body at all. From the perspective of a solar cell structure, a region corresponding to the single collector electrode on the solar cell body is locally covered by the first conductive contact layer, to achieve that the collector electrode is in partial direct contact with and in partial no contact with the solar cell body; and the region corresponding to the single collector electrode on the solar cell body is completely covered by the first conductive contact layer, to achieve that the collector electrode is not in contact with the solar cell body at all. In this case, compared with the conventional technologies, a metal composite loss between the collector electrode and the solar cell body can be reduced or eliminated, thereby improving solar cell efficiency of the back contact solar cell. Further, because the projection of the single bus electrode on the solar cell body at least partially overlaps with the projection of the corresponding second conductive contact layers on the solar cell body, there is a case in which the single bus electrode is in partial direct contact with the solar cell body or the bus electrode is not in contact with the solar cell body at all. From the perspective of the solar cell structure, a region corresponding to the single bus electrode on the solar cell body is locally covered by the second conductive contact layer, to achieve that the bus electrode is in partial direct contact with and in partial no contact with the solar cell body; and the region corresponding to the single bus electrode on the solar cell body is completely covered by the second conductive contact layer, to achieve that the bus electrode is not in contact with the solar cell body at all. Preferably, a region corresponding to each of the collector electrodes on the solar cell body in the back contact solar cell is completely covered by a first conductive contact layer, and a region corresponding to each of the bus electrodes on the solar cell body in the back contact solar cell is completely covered by a second conductive contact layer, so that all of the collector electrodes and all of the bus electrodes are not in contact with the solar cell body at all. In this case, compared with the conventional technologies, a metal composite loss between the bus electrode and the solar cell body can be further reduced or eliminated, and an open-circuit voltage of the back contact solar cell can increase, thereby improving the solar cell efficiency of the back contact solar cell. Based on the above, the back contact solar cell provided in this embodiment of this application is used, so that a metal composite loss on a surface of the back contact solar cell can be reduced or eliminated, thereby improving the solar cell efficiency of the back contact solar cell.

For example, for the metal composite loss, contact between metal and a semiconductor is not a simple connection between the metal and the semiconductor, but the metal and the semiconductor form a metal-semiconductor alloy. In a process of forming the alloy, in addition to the alloy, some scattered metal powders are free in the semiconductor. The metal powders in such a state in the semiconductor are deep-level impurities, do not participate in electrical conduction, and serve as composition centers to trap electrons transmitted from a valence band to a guide band, resulting in a severe metal composite loss. Because the first conductive contact layer and the second conductive contact layer in this embodiment of this application have high doping concentrations and can form an alloy together with a large amount of metal, generated free metal particles are small. Further, because the first conductive contact layer and the second conductive contact layer include a doped polysilicon layer and a tunneling layer and the metal generally does not pass through the tunneling layer to come into contact with the solar cell body, the metal composite loss is reduced.

Compared with the conventional technologies, in this embodiment of this application, the metal composite loss is reduced by 1 fA to 20 fA, and the open-circuit voltage is improved by 1 mV to 10 mV.

It should be understood that, the back contact solar cell may be a sliced back contact solar cell, or may be an entire back contact solar cell.

In a possible implementation, the first direction and the second direction may be any two directions parallel to a surface of the semiconductor substrate and different from each other. Preferably, referring to FIG. 3 to FIG. 5 with reference to FIG. 1 and FIG. 2, the first direction A and the second direction B are orthogonal.

In a possible implementation, a first conductive contact layer and a second conductive contact layer that are adjacent and have a same polarity intersect. The intersection between the first conductive contact layer and the second conductive contact layer improves collection of carriers, shortens a transmission path of the carriers, reduces a current loss, and improves efficiency of the solar cell.

In a possible implementation, the single bus electrode is connected to a part of collector electrodes having the same polarity as that of the bus electrode, where the second conductive contact layer corresponding to the bus electrode is connected to first conductive contact layers corresponding to the part of the collector electrodes. The solar cell body is located below the conductive contact layer, and resistance of the solar cell body is greater than resistance of the conductive contact layer. Therefore, when a current is transmitted to the conductive contact layer through the solar cell body, and then to the collector electrode and the bus electrode, a current loss can be reduced compared with the case in which the first conductive contact layer and the second conductive contact layer are disconnected.

In a possible implementation, for that "a projection of a collector electrode on the solar cell body at least partially overlaps with a projection of a first conductive contact layer on the solar cell body", there are a plurality of cases described below. It should be understood that, the following descriptions are merely for understanding and are not intended to be specifically limited.

Example 1: A projection of a single collector electrode on the solar cell body completely overlaps with a projection of a corresponding first conductive contact layer on the solar cell body. The case may also be understood as that the projection of the single collector electrode on the solar cell body is located within the projection of the corresponding first conductive contact layer on the solar cell body. In this case, an area of the first conductive contact layer is greater than or equal to an area of the corresponding collector electrode, and a region corresponding to the single collector electrode on the solar cell body is completely covered by the first conductive contact layer, so that the collector electrode is not in contact with the solar cell body at all.

Example 2: A projection of a single collector electrode on the solar cell body partially overlaps with a projection of a corresponding first conductive contact layer on the solar cell body. Specifically, the two projections alternately overlap.

Example 3: Projections of the plurality of collector electrodes on the solar cell body partially overlap with projections of the plurality of first conductive contact layers on the solar cell body as a whole. Specifically, a first conductive contact layer is arranged below each of one part of the collector electrodes in the plurality of collector electrodes, and a projection of each of the one part of the collector electrodes on the solar cell body completely or alternately overlaps with a projection of the corresponding first conductive contact layer on the solar cell body. No first conductive contact layer is arranged below the other part of the collector electrodes in the plurality of collector electrodes.

In a possible implementation, for that "a projection of a bus electrode on the solar cell body at least partially overlaps with a projection of a second conductive contact layer on the solar cell body", there are a plurality of cases described below. It should be understood that, the following descriptions are merely for understanding and are not intended to be specifically limited.

Example 1: A projection of a single bus electrode on the solar cell body completely overlaps with a projection of a corresponding second conductive contact layer on the solar cell body. The case may also be understood as that the projection of the bus electrode on the solar cell body is located within the projection of the second conductive contact layer on the solar cell body. In this case, an area of the second conductive contact layer is greater than or equal to an area of the corresponding bus electrode, and a region corresponding to the single bus electrode and the solar cell body is completely covered by the second conductive contact layer, so that the bus electrode is not in contact with the solar cell body at all.

Example 2: A projection of a single bus electrode on the solar cell body partially overlaps with a projection of a corresponding second conductive contact layer on the solar cell body. Specifically, the two projections alternately overlap.

Example 3: Projections of the plurality of bus electrodes on the solar cell body partially overlap with projections of the plurality of second conductive contact layers on the solar cell body as a whole. Specifically, a second conductive contact layer is arranged below each of one part of the bus electrodes in the plurality of bus electrodes, and a projection of each of the one part of the bus electrodes on the solar cell body completely or alternately overlaps with a projection of the corresponding second conductive contact layer on the solar cell body. No second conductive contact layer is arranged below the other part of the bus electrodes in the plurality of bus electrodes.

In a possible implementation, referring to FIG. 3 to FIG. 6 with reference to FIG. 1 and FIG. 2, each of the collector electrodes 4 includes collector electrode sections 40, and each of the collector electrode sections 40 is spaced apart from a bus electrode 5 adjacent to the collector electrode 4 and having a polarity opposite to that of the collector electrode 4. A part of each of the collector electrodes located between two adjacent bus electrodes is a collector electrode section. A length of a first conductive contact layer 10 corresponding to any collector electrode section 40 located between two adjacent bus electrodes 5 is greater than or equal to 5 mm and less than or equal to 50 mm, and a length direction of the first conductive contact layer 10 is consistent with the first direction A. For example, the length of the first conductive contact layer 10 may be 5 mm, 8 mm, 19 mm, 25 mm, 32 mm, 40 mm, 46 mm, 50 mm, or the like.

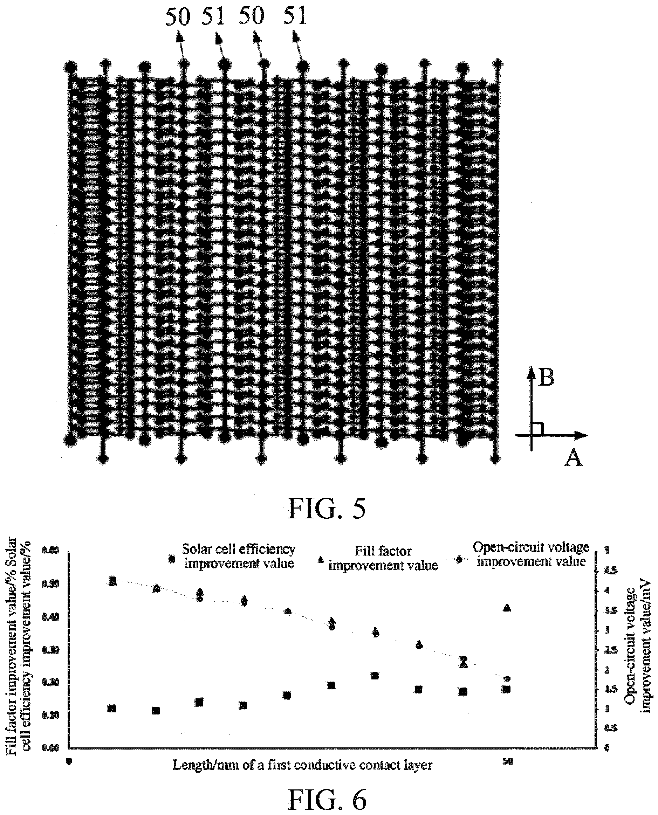

Because the length of the first conductive contact layer is greater than or equal to 5 mm, in this case, an excessively short distance for the first conductive contact layer to collect a current caused by an excessively small length of the first conductive contact layer can be avoided. In this way, a capability of the first conductive contact layer to collect the current can be ensured, and the solar cell efficiency of the back contact solar cell can be improved. Further, because the length of the first conductive contact layer is less than or equal to 50 mm, in this case, more first conductive contact layers can be formed on the solar cell body, to form more second conductive contact layers, so that more bus electrodes can be formed. In this way, the solar cell efficiency of the back contact solar cell can be improved, and the open-circuit voltage and a passivation effect of the back contact solar cell can be improved. Referring to FIG. 6, in the foregoing value range, the solar cell efficiency of the back contact solar cell has an increasing trend as a whole compared with the conventional technologies. It should be noted that, a solar cell efficiency improvement value in FIG. 6 is an improved value compared with solar cell efficiency in the conventional technologies, and all "improvement values" in this specification are improved values compared with the conventional technologies.

For example, the length of the first conductive contact layer provided in this embodiment of this application is small. In this case, compared with a case in which the length of the first conductive contact layer is large, when a spacing between two adjacent first conductive contact layers is unchanged and a size of the solar cell body is unchanged, more first conductive contact layers can be formed in the first direction A, to form more second conductive contact layers, so that more bus electrodes can be formed.

In a possible implementation, when the back contact solar cell is the sliced solar cell, a length of the second conductive contact layer is less than half of a length of the solar cell body. When the back contact solar cell is the entire solar cell, the length of the second conductive contact layer is less than the length of the solar cell body. A length direction of the second conductive contact layer and a length direction of the solar cell body are consistent with the second direction B.

In a possible implementation, the projection of the collector electrode on the solar cell body is located within the projection of the first conductive contact layer on the solar cell body.

With the foregoing technical solution, while it is ensured that the collector electrode is in contact with the first conductive contact layer, the metal composite loss between the collector electrode and the solar cell body can be reduced or eliminated, and the open-circuit voltage of the back contact solar cell can increase, thereby improving the solar cell efficiency of the back contact solar cell. Further, because the first conductive contact layer is in good contact with the collector electrode, in this case, the collector electrode can collect a current, thereby facilitating transmission of the current.

In a possible implementation, the projection of the bus electrode on the solar cell body is located within the projection of the second conductive contact layer on the solar cell body.

With the foregoing technical solution, while it is ensured that the bus electrode is in contact with the second conductive contact layer, the metal composite loss between the bus electrode and the solar cell body can be reduced or eliminated, and the open-circuit voltage of the back contact solar cell can increase, thereby improving the solar cell efficiency of the back contact solar cell. Further, reflection by the bus electrode on light is used, so that blocking by the second conductive contact layer on the solar cell body can be reduced or eliminated, thereby reducing impact on light absorption by the back contact solar cell, and improving the solar cell efficiency of the back contact solar cell.

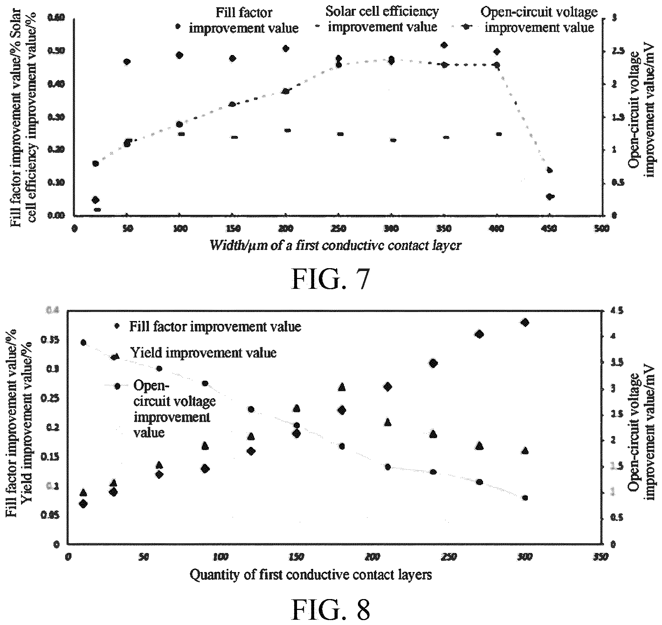

In a possible implementation, referring to FIG. 7, a width of the first conductive contact layer is greater than or equal to 50 µm and less than or equal to 400 µm, and a width direction of the first conductive contact layer is consistent with the second direction. For example, the width of the first conductive contact layer may be 50 µm, 90 µm, 120 µm, 180 µm, 260 µm, 320 µm, 380 µm, 400 µm, or the like.

In a process of manufacturing the back contact solar cell, the collector electrode needs to be printed above the first conductive contact layer. In a current printing technology, the collector electrode can be printed on only a line with a minimum width of about 50 µm (namely, the first conductive contact layer in this embodiment of this application). If a width of the line is excessively small, the projection of the collector electrode on the solar cell body cannot at least partially overlap with the projection of the first conductive contact layer on the solar cell body, and the collector electrode does not fall within a first conductive contact region generated by the first conductive contact layer. In other words, when the width of the first conductive contact layer is less than 50 µm, a printing offset of the collector electrode is caused. The printing offset causes various parameters of the back contact solar cell to greatly decrease. In the most severe case, first conductivity type regions and second conductivity type regions (namely, N regions and P regions of the back contact solar cell in the conventional technologies) of the back contact solar cell are short-circuited, causing the solar cell efficiency of the back contact solar cell to be drastically reduced. In this way, the width of the first conductive contact layer is greater than or equal to 50 µm.

Because the width of the first conductive contact layer is less than or equal to 400 µm, in this case, an excessively small quantity of first conductive contact layers caused by an excessively large width of the first conductive contact layer can be avoided, thereby avoiding reducing a quantity of collector electrodes. In this way, a decrease in a contact area between the metal and the semiconductor can be avoided, thereby avoiding a decrease in a fill factor of the back contact solar cell. Further, when the width of the first conductive contact layer is less than or equal to 400 µm, a spacing between two adjacent first conductive contact layers can be large, that is, a size of a gap in an up-down direction can be large. Because an up-down offset in the printing offset has the largest impact, the N regions and the P regions are connected over a large area and therefore short-circuited. In this way, when the width of the first conductive contact layer is less than or equal to 400 µm, printing difficulty can be reduced, the printing offset can be reduced, and a printing yield of the back contact solar cell can increase. Still further, a composition loss can be avoided and a printing offset rate can be reduced while contact is ensured, so that both the solar cell efficiency and the yield of the back contact solar cell are improved. Still further, the width of the first conductive contact layer is controlled, so that blocking by the first conductive contact layer on the solar cell body can be reduced or eliminated, thereby reducing impact on light absorption by the back contact solar cell, and improving the solar cell efficiency of the back contact solar cell.

For example, the width of the first conductive contact layer provided in this embodiment of this application is small. In this case, compared with a case in which the width of the first conductive contact layer is large, when the quantity of first conductive contact layers is unchanged and the size of the solar cell body is unchanged, a spacing (namely, the second spacing) between adjacent first conductive contact layers in the second direction B can increase, thereby improving the yield of the back contact solar cell.

Referring to FIG. 7, when the width of the first conductive contact layer is greater than or equal to 50 µm and less than or equal to 400 µm, the solar cell efficiency of the back contact solar cell has an increasing trend as a whole compared with the conventional technologies.

In a possible implementation, referring to FIG. 8, as the quantity of first conductive contact layers continuously increases, the fill factor of the back contact solar cell continuously increases. However, due to a metal composite loss caused by the contact between the metal and the semiconductor, the open-circuit voltage slightly decreases, but the open-circuit voltage generally increases compared with the conventional technologies. Further, because the second spacing is excessively small, the yield of the back contact solar cell decreases, but the yield generally increases compared with the conventional technologies.

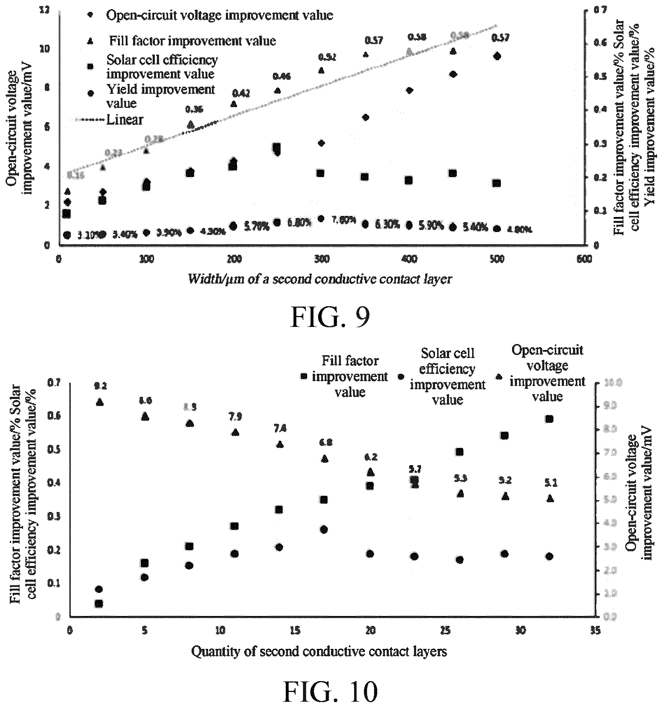

In a possible implementation, referring to FIG. 9, a width of the second conductive contact layer is greater than or equal to 50 µm and less than or equal to 400 µm, and a width direction of the second conductive contact layer is consistent with the first direction. For example, the width of the second conductive contact layer may be 50 µm, 90 µm, 120 µm, 180 µm, 260 µm, 320 µm, 380 µm, 400 µm, or the like.

Because the width of the second conductive contact layer is greater than or equal to 50 µm, in this case, the open-circuit voltage, the fill factor, and the solar cell efficiency of the back contact solar cell can be improved. Further, because the width of the second conductive contact layer is less than or equal to 400 µm, in this case, an excessively small length of a first conductive contact layer located between two adjacent second conductive contact layers caused by an excessively large width of the second conductive contact layer can be avoided, thereby avoiding an excessively short distance for the first conductive contact layer and a collector electrode corresponding to the first conductive contact layer to collect a current, and avoiding affecting the yield. In this way, impact on collection of the first conductive contact layer on the current can be avoided, and the yield of the back contact solar cell can be improved. Still further, the width of the second conductive contact layer is controlled, so that blocking by the second conductive contact layer on the solar cell body can be reduced or eliminated, thereby reducing impact on light absorption by the back contact solar cell, and improving the solar cell efficiency of the back contact solar cell.

In a possible implementation, referring to FIG. 10, as the quantity of second conductive contact layers continuously increases, the fill factor of the back contact solar cell significantly increases. However, improvement of the open-circuit voltage decreases (that is, an open-circuit voltage improvement value shown in FIG. 10 decreases), but the open-circuit voltage generally increases compared with the conventional technologies. The reason is as follows: Because the back surface of the solar cell body is covered with the first conductivity type regions, the second conductivity type regions, and the isolation regions, when the quantity of second conductive contact layers increases, a first spacing between the first conductive contact layer corresponding to the collector electrode section and a second conductive contact layer corresponding to the bus electrode adjacent to the collector electrode and having the polarity opposite to that of the collector electrode is excessively small, resulting a decrease in the open-circuit voltage and a decrease in the yield of the back contact solar cell. A direction of the first spacing is consistent with the first direction.

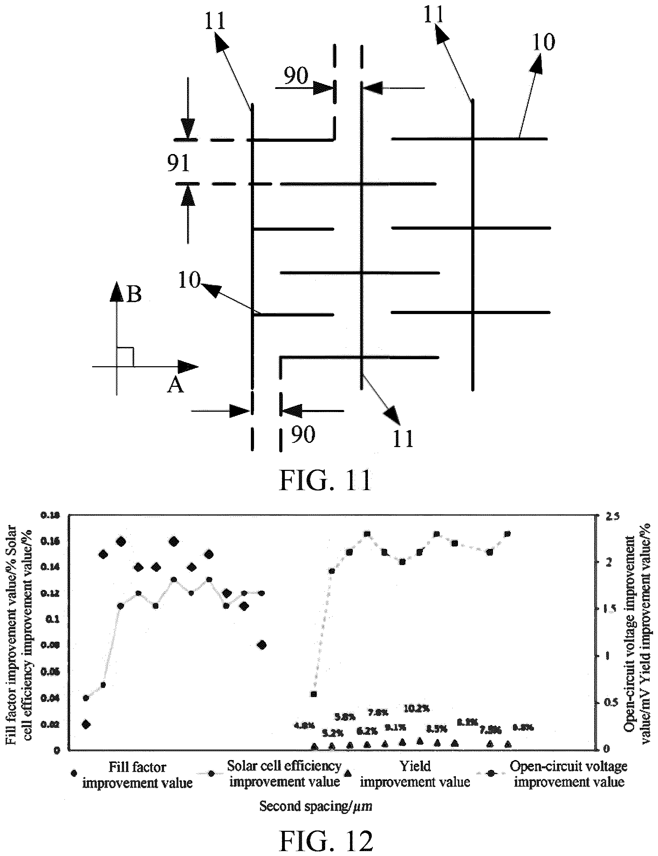

In an optional manner, referring to FIG. 11, a first spacing 90 is greater than or equal to 5 µm and less than or equal to 100 µm, and a direction of the first spacing 90 is consistent with the first direction. For example, the first spacing 90 may be 5 µm, 16 µm, 37 µm, 48 µm, 69 µm, 82 µm, 100 µm, or the like.

With the foregoing technical solution, because the first spacing is greater than or equal to 5 µm, in this case, conduction between a first conductivity type region and a second conductivity type region (namely, an N region and a P region of the back contact solar cell in the conventional technologies) can be avoided, thereby avoiding a short circuit. In addition, a printing offset can be reduced or avoided, to further reduce or avoid a short circuit caused by conduction of the N region and the P region. Further, because the first spacing is less than or equal to 100 µm, in this case, excessively small areas of the N region and the P region when the first spacing is greater than 100 µm can be reduced or avoided, to reduce or avoid passivation deterioration, a decrease in a contact area between the metal and the semiconductor, and a decrease in a fill factor of the back contact solar cell caused by the excessively small areas of the N region and the P region, thereby ensuring or improving the solar cell efficiency of the back contact solar cell.

In an optional manner, referring to FIG. 11 and FIG. 12, a second spacing 91 between any two adjacent first conductive contact layers is greater than or equal to 5 µm and less than or equal to 100 µm, and a direction of the second spacing 91 is consistent with the second direction. For example, the second spacing 91 may be 5 µm, 16 µm, 37 µm, 48 µm, 69 µm, 82 µm, 100 µm, or the like.

With the foregoing technical solution, because the second spacing is greater than or equal to 5 µm, in this case, a short circuit between two collector electrode sections having opposite polarities caused by an excessively short distance between two adjacent first conductive contact layers can be avoided, to ensure that the collector electrode sections are connected to corresponding bus electrodes, thereby ensuring quality of the back contact solar cell, and ensuring the solar cell efficiency and a yield of the back contact solar cell. Further, because the second spacing is less than or equal to 100 µm, in this case, excessively small areas of a first conductivity type region and a second conductivity type region caused by an excessively large second spacing can be avoided, to avoid a decrease in the fill factor, thereby ensuring the solar cell efficiency and the yield of the back contact solar cell.

In a possible implementation, referring to FIG. 12, as the second spacing increases, a fill factor improvement value first increases, then remains at a high level in a specific range of the second spacing, and then decreases. Initially, the reason for the increase in the fill factor improvement value is as follows: An excessively small second spacing causes a part of first conductivity type regions and a part of second conductivity type regions to be incompletely separated, resulting in existence of a local communication point. Therefore, in the interval, as the second spacing increases, the fill factor improvement value increases. As the second spacing increases, the fill factor of the back contact solar cell gradually recovers to a preferred level as the communication point decreases. Then, if the second spacing continuously increases, the fill factor improvement value decreases. Specifically, because the area of the first conductive contact layer decreases, the contact area between the metal and the semiconductor decreases, resulting in the decrease in the fill factor.

In a possible implementation, when a total area of the solar cell body is unchanged, when the area of the first conductive contact layer decreases, an area at a gap increases. Further, when the length of the gap is unchanged, the second spacing increases. Because the size of the second spacing increases, collector electrodes in the N region and the P region are less likely to be conducted at the second spacing to be short-circuited. In this way, the solar cell efficiency of the back contact solar cell is improved overall, and the yield of the back contact solar cell is greatly improved.

In a possible implementation, a thickness of the conductive contact layer is greater than or equal to 30 nm and less than or equal to 600 nm, and a thickness direction of the conductive contact layer is perpendicular to the first direction and the second direction. For example, the thickness of the conductive contact layer may be 30 nm, 50 nm, 180 nm, 200 nm, 380 nm, 460 nm, 600 nm, or the like.

Because the thickness of the conductive contact layer is greater than or equal to 30 nm, in this case, a probability that materials for manufacturing the bus electrodes and the collector electrodes pass through the solar cell body can be reduced or eliminated, to reduce or eliminate the metal composite loss on the surface of the back contact solar cell, thereby improving the solar cell efficiency of the back contact solar cell. Because the thickness of the conductive contact layer is less than or equal to 600 nm, in this case, light absorption by the conductive contact layer can be reduced, to reduce parasitic light absorption, thereby avoiding a severe decrease in a current of the back contact solar cell. In addition, bending and deformation of the back contact solar cell caused by unconcentrated stress distribution can also be avoided, thereby reducing a fragmentation rate in a production process, and improving a yield of the back contact solar cell.

In a possible implementation, referring to FIG. 3 to FIG. 5 with reference to FIG. 1 and FIG. 2, the solar cell body includes first conductivity type regions 6, second conductivity type regions 7, and isolation regions 8. The first conductivity type regions 6 and the second conductivity type regions 7 have opposite conductivity types and are alternately distributed. Each of the isolation regions 8 is located between a first conductivity type region 6 and a second conductivity type region 7. One of a positive electrode 2 and a negative electrode 3 is located in the first conductivity type region 6, and the other of the positive electrode 2 and the negative electrode 3 is located in the second conductivity type region 7. A ratio of a sum of areas of the first conductivity type regions 6 and the second conductivity type regions 7 to an area of the solar cell body is greater than or equal to 10% and less than or equal to 50%. For example, the ratio may be 10%, 13%, 16%, 21%, 30%, 38%, 45%, 50%, or the like. Because a side area of the solar cell body can be ignored, the area of the solar cell body in this specification is a sum of areas of a first surface and a second surface of the solar cell body, that is, a sum of an area of a back surface and an area of a light receiving surface.

With the foregoing technical solution, because the first conductivity type regions and the second conductivity type regions are alternately distributed, in this case, when it is ensured that the first conductivity type regions and the second conductivity type regions are evenly distributed on the entire back surface of the solar cell body, it can be ensured that the first conductivity type regions and the second conductivity type regions of the back contact solar cell have large areas, and overall transmission of currents to the first conductivity type regions and the second conductivity type regions can also be facilitated, thereby avoiding a large composition loss of carriers caused by an excessively long transmission distance.

In this embodiment of this application, the positive electrode 2 is located in the first conductivity type region 6, and the negative electrode 3 is located in the second conductivity type region 7.

In an optional manner, a ratio of a total area of the isolation regions to the area of the solar cell body is greater than or equal to 1% and less than or equal to 10%. For example, the ratio may be 1%, 3%, 5%, 6%, 8%, 9%, 10%, or the like.

With the foregoing technical solution, the first conductivity type regions and the second conductivity type regions can be completely separated, and it can also be ensured that distribution areas of the first conductivity type regions and the second conductivity type regions are not occupied too much. In this way, the passivation effect of the entire back contact solar cell and contact between the metal and the semiconductor can be ensured, so that the open-circuit voltage and a fill factor of the back contact solar cell are improved, thereby improving the solar cell efficiency of the back contact solar cell.

In a possible implementation, referring to FIG. 3 to FIG. 5, a ratio of a total area of the second conductive contact layers to an area of the conductive contact layer is greater than or equal to 2% and less than or equal to 20%. For example, the ratio may be 2%, 8%, 10%, 13%, 18%, 19%, 20%, or the like.

With the foregoing technical solution, because the ratio is greater than or equal to 2% and less than or equal to 20%, in this case, it can be ensured that there is a case in which the bus electrode is in partial direct contact with the solar cell body or the bus electrode is not in contact with the solar cell body at all, thereby reducing or eliminating the metal composite loss between the bus electrode and the solar cell body; and further, in this case, distribution areas of the first conductivity type regions and the second conductivity type regions can be ensured, and the total area of the second conductive contact layers can be ensured, thereby avoiding a decrease in a contact area between the metal and the semiconductor caused by a decrease in the total area of the second conductive contact layers. In this way, a fill factor of the back contact solar cell can be ensured, thereby ensuring or improving the solar cell efficiency of the back contact solar cell.

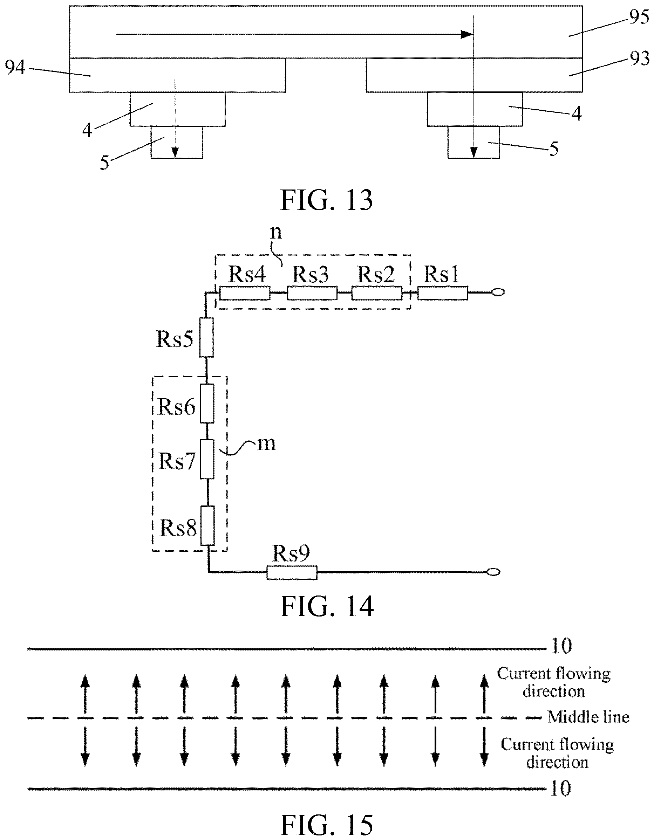

Based on the above, because the back contact solar cell includes the first conductive contact layers and the second conductive contact layers, in this case, contact resistivity can be reduced and series resistance can be reduced, thereby effectively collecting currents, and improving the solar cell efficiency of the back contact solar cell. For example, the contact resistivity decreases by 0.1 mΩ*cm² to 2 mΩ*cm², and the series resistance decreases by 0.01 mΩ to 0.5 mΩ. FIG. 13, FIG. 14, and FIG. 17 are respectively a schematic diagram of a current flowing direction in a back contact solar cell according to an embodiment of this application, a schematic diagram of series resistance in a back contact solar cell according to an embodiment of this application, and a schematic structural diagram of a back contact solar cell according to an embodiment of this application. Rs1 represents resistance of an N-region bus electrode, Rs2 represents resistance of an N-region collector electrode, Rs3 represents metal-semiconductor contact resistance between the collector electrode and an N-region first conductive contact layer 93, Rs4 represents resistance of the N-region first conductive contact layer, n represents a quantity of lines of N-type first conductive contact layers, Rs5 represents resistance of a solar cell body 95, Rs9 represents resistance of a P-region bus electrode, Rs8 represents resistance of a P-region collector electrode, Rs7 represents metal-semiconductor contact resistance between the collector electrode and a P-region first conductive contact layer 94, Rs6 represents resistance of the P-region first conductive contact layer, and m represents a quantity of lines of P-region first conductive contact layers.

When sunlight shines on the back contact solar cell, a large quantity of photo-generated carriers are generated inside the entire back contact solar cell (where arrows in FIG. 13 point in transmission directions of the photo-generated carriers). The photo-generated carriers are first transmitted to N regions and P regions through the solar cell body under action of an internal electric field. The collector electrodes collect currents collected in the N regions and the P regions through contact between the metal and the semiconductor, and are equivalent to positive electrodes and negative electrodes of the solar cell. The N regions and the P regions are evenly distributed on the entire back surface of the back contact solar cell, so that the photo-generated carriers can be quickly collected toward nearest N regions and P regions, the collector electrodes can also collect currents in the N regions and the P regions, and the carriers collected in the collector electrodes are evenly distributed on the surface. However, this is not conducive to different solar cells being connected into a module and being connected to a load. Therefore, the bus electrodes are further required to collect the currents collected in the collector electrodes for connection into a solar cell module. n and m are changed by changing the length of the first conductive contact layer, to affect an overall resistance change. Further, if a total quantity of first conductive contact layers is unchanged, when the length of the first conductive contact layers decreases and a quantity of first conductive contact layers in the length direction increases, a quantity of first conductive contact layers in the width direction can decrease, the width of the first conductive contact layer can increase, a quantity of second spacings can decrease, and a size of the second spacing can increase. In this case, a printing offset can be reduced, to reduce or avoid a short circuit caused by conduction of the collector electrodes in the N regions and the P regions, thereby improving the yield.

Further, if the contact resistivity and the series resistance of the back contact solar cell are large, the contact resistivity and the series resistance of the back contact solar cell greatly decrease after the first conductive contact layers and the second conductive contact layers are arranged. In addition, because the series resistance decreases, in this case, the fill factor of the back contact solar cell significantly increases by 0.05% to 0.8%.

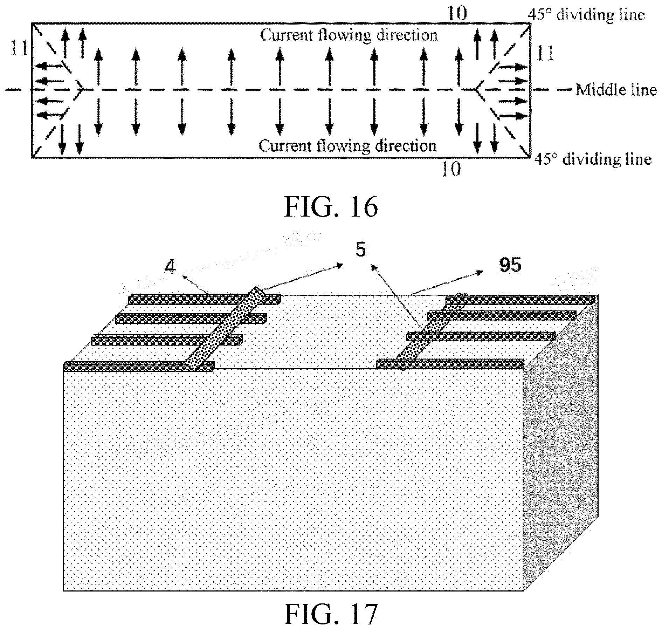

Still further, FIG. 15 shows a current flowing direction when only first conductive contact layers 10 are arranged. FIG. 16 shows a current flowing direction when both first conductive contact layers 10 and second conductive contact layers 11 are arranged. It can be learned that, when both the first conductive contact layers 10 and the second conductive contact layers 11 are arranged, a transmission distance of a current can be further reduced, thereby reducing a current loss.

The current loss, a shading loss, and the metal composite loss are collectively referred to as a total loss. A total loss of the back contact solar cell in the conventional technologies ranges from 30 mA to 500 mA, and a total loss of the back contact solar cell provided in this embodiment of this application ranges from 10 mA to 100 mA, and an average composite current loss of a monolithic solar cell decreases by 5 mA to 100 mA.

According to a second aspect, an embodiment of this application further provides a photovoltaic module, including the back contact solar cell according to the foregoing technical solutions.

Compared with the conventional technologies, beneficial effects of the photovoltaic module provided in this embodiment of this application are the same as the beneficial effects of the back contact solar cell in the foregoing technical solutions, and details are not described herein again.

In the descriptions of the foregoing implementations, the described specific features, structures, materials, or characteristics may be combined in a proper manner in any one or more of the embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A back contact solar cell, comprising: a solar cell body, a conductive contact layer (1) formed on a back surface of the solar cell body, and positive electrodes (2) and negative electrodes (3) located on the conductive contact layer (1) , wherein each of a group of the positive electrodes (2) and a group of the negative electrodes (3) comprises a plurality of collector electrodes (4) and a plurality of bus electrodes (5); the conductive contact layer (1) comprises a plurality of first conductive contact layers (10) and a plurality of second conductive contact layers (11);
the plurality of collector electrodes (4) comprised in the group of the positive electrodes (2) and the plurality of collector electrodes (4) comprised in the group of the negative electrodes (3) extend in a first direction and are alternately spaced apart in a second direction;
the plurality of first conductive contact layers (10) extend in the first direction and are spaced apart in the second direction;
the plurality of bus electrodes (5) comprised in the group of the positive electrodes (2) and the plurality of bus electrodes (5) comprised in the group of the negative electrodes (3) extend in the second direction and are alternately spaced apart in the first direction;
the plurality of second conductive contact layers (11) extend in the second direction and are spaced apart in the first direction;
the first direction is different from the second direction; each of the bus electrodes (5) is connected to collector electrodes (4) having the same polarity as that of the bus electrode(5);
a projection of a collector electrode (4) on the solar cell body at least partially overlaps with a projection of a first conductive contact layer (10) on the solar cell body; and a projection of a bus electrode (5) on the solar cell body at least partially overlaps with a projection of a second conductive contact layer (11) on the solar cell body.

2. The back contact solar cell according to claim 1, wherein the solar cell body comprises first conductivity type regions (6), second conductivity type regions (7), and isolation regions (8);
the first conductivity type regions (6) and the second conductivity type regions (7) have opposite conductivity types and are alternately distributed; each of the isolation regions (8) is located between a first conductivity type region (6) and a second conductivity type region (7);
one of a positive electrode (2) and a negative electrode (3) is located in the first conductivity type region (6), and the other of the positive electrode (2) and the negative electrode (3) is located in the second conductivity type region (7); and
a ratio of a sum of areas of the first conductivity type regions (6) and the second conductivity type regions (7) to an area of the solar cell body is greater than or equal to 10% and less than or equal to 50%.

3. The back contact solar cell according to any one of claims 1 or 2, wherein the solar cell body comprises first conductivity type regions (6), second conductivity type regions (7), and isolation regions (8);
the first conductivity type regions (6) and the second conductivity type regions (7) have opposite conductivity types and are alternately distributed; each of the isolation regions (8) is located between a first conductivity type region (6) and a second conductivity type region (7);
a ratio of a total area of the isolation regions (8) to an area of the solar cell body is greater than or equal to 1% and less than or equal to 10%.

4. The back contact solar cell according to any one of claims 1 to 3, wherein a ratio of a total area of the second conductive contact layers (11) to an area of the conductive contact layer (1) is greater than or equal to 2% and less than or equal to 20%.

5. The back contact solar cell according to any one of claims 1 to 4, wherein each of the collector electrodes (4) comprises collector electrode sections (40), and each of the collector electrode sections (40) is spaced apart from a bus electrode (5) adjacent to the collector electrode (4) and having a polarity opposite to that of the collector electrode (4); and
a length of a first conductive contact layer (10) corresponding to any collector electrode section (40) located between two adjacent bus electrodes (5) is greater than or equal to 5 mm and less than or equal to 50 mm, and a length direction of the first conductive contact layer (10) is consistent with the first direction.

6. The back contact solar cell according to claim 5, wherein a first spacing (90) between the first conductive contact layer (10) corresponding to the collector electrode section (40) and a second conductive contact layer (11) corresponding to the bus electrode (5) adjacent to the collector electrode (4) and having the polarity opposite to that of the collector electrode (4) is greater than or equal to 5 µm and less than or equal to 100 µm, and a direction of the first spacing (90) is consistent with the first direction; and/or
a second spacing (91) between any two adjacent first conductive contact layers (10) is greater than or equal to 5 µm and less than or equal to 100 µm, and a direction of the second spacing (91) is consistent with the second direction.

7. The back contact solar cell according to any one of claims 1 to 6, wherein the projection of the collector electrode (4) on the solar cell body is located within the projection of the first conductive contact layer (10) on the solar cell body; and/or
the projection of the bus electrode (5) on the solar cell body is located within the projection of the second conductive contact layer (11) on the solar cell body.

8. The back contact solar cell according to any one of claims 1 to 7, wherein a width of the first conductive contact layer (10) is greater than or equal to 50 µm and less than or equal to 400 µm, and a width direction of the first conductive contact layer (10) is consistent with the second direction; and/or
a width of the second conductive contact layer (11) is greater than or equal to 50 µm and less than or equal to 400 µm, and a width direction of the second conductive contact layer (11) is consistent with the first direction.

9. The back contact solar cell according to any one of claims 1 to 8, wherein a thickness of the conductive contact layer (1) is greater than or equal to 30 nm and less than or equal to 600 nm, and a thickness direction of the conductive contact layer (1) is perpendicular to the first direction and the second direction.

10. The back contact solar cell according to any one of claim 1 to 9, wherein a first conductive contact layer (10) and a second conductive contact layer (11) that are adjacent and have a same polarity intersect.

11. A photovoltaic module, comprising the back contact solar cell according to any one of claims 1 to 10.
